Europäisches Patentamt

European Patent Office

Office européen des brevets

(11) Publication number: **0 096 509**
A2

# (12) EUROPEAN PATENT APPLICATION

(21) Application number: 83302988.7

(22) Date of filing: 24.05.83

(51) Int. Cl.³: **H 01 L 33/00**

(30) Priority: 09.06.82 GB 8216684
12.10.82 GB 8229090

(43) Date of publication of application:
21.12.83 Bulletin 83/51

(84) Designated Contracting States:
DE FR NL

(71) Applicant: NATIONAL RESEARCH DEVELOPMENT
CORPORATION
101 Newington Causeway
London SE1 6UP(GB)

(72) Inventor: Reehal Haricharan Singh
48 Ederoyd Crescent
Pudsey Leeds Yorkshire LS28 7QU(GB)

(72) Inventor: Thomas, Clive Barrington
24 Daleway
Guisley, Leeds YOrkshire(GB)

(72) Inventor: Gallego, JOse Manuel
22 Ellerbrook Drive
Latham Lancashire L40 5SX(GB)

(74) Representative: Williams, Arthur Wyn Spencer et al,
Procurement Executive, Ministry of Defence Patents
1A(4), Room 2014 Empress State Building Lillie Road
London SW6 1TR(GB)

(54) Electroluminescent devices.

(57) An electroluminescent device (10, . . . 60) comprises an electroluminescent layer (11, . . . 61) together with a p-type silicon layer (13, . . . 63) and an n-type silicon layer (14, . . . 64). The layers (11,13,14, . . . 61,63,64) constitute a heterojunction or transistor-like structure which limits the total device current during operation. This avoids current runaway experienced in prior art devices, and has been found to extend operating life. The electroluminescent layer (21,31,41) may be in contact with a transition metal oxide layer (25,35,45) to provide self-healing of pinholes. The electroluminescent device (30) may include additional p-type and n-type silicon layers (36 and 37) to provide a degree of current control. The p-type silicon layer (43,53,63) may be connected to an ohmic contact (48,58,68) for control of device current. The silicon layers (13,14, . . . 63,64,36,37) are either crystalline or amorphous.

TITLE:  ELECTROLUMINESCENT DEVICE

This invention relates to an electroluminescent device.

Electroluminescent devices are known, and may comprise a substrate bearing a thin film of electroluminescent material between conducting electrodes at least one of which is transparent.  ZnS doped with Mn is a typical electroluminescent material in which electroluminescence arises it is thought from impact-excitation of the Mn ions by "hot" electrons.  The electrode/ZnS interface forms a junction with  a barrier height much greater than kT, and this junction limits carrier injection.  Luminescence is thus necessarily accompanied by avalanching or similar  high field behaviour.

Electron avalanching may frequently be accompanied by deleterious effects in ZnS:Mn films.  In particular, localised regions of high electric fields can cause break-up of the films.  This requires control over the avalanche current during luminescence or light emission.

It is an object of the present invention to provide an electroluminescent device including means for restricting the avalanche current.

The present invention provides an electroluminescent device including an electroluminescent layer together with p-type and n-type layers of silicon.  The electroluminescent and silicon layers have been found to form a heterojunction or transistor-like structure having the advantage of restricting the avalanche current as compared to prior art devices.

In a preferred embodiment, the electroluminescent device includes a manganese-doped zinc sulphide electroluminescent layer and the n-type silicon layer has $n^+$ doping.

The device may include a transition metal oxide layer in contact with the electroluminescent layer but remote from the silicon layers to provide self-healing of pinholes in the electroluminescent layer.

The silicon layers are either crystalline or amorphous. In the case of amorphous silicon layers, the electroluminescent device may have an amorphous substrate such as glass, which is advantageous for large area devices.

The p-type silicon layer may be connected to a control electrode for controlling the current in the device.

The electroluminescent device may include additional p-type and n-type silicon layers such that the device becomes equivalent to electroluminescent and p-type silicon layers in series with an n-p-n transistor for current control purposes.

The manganese-doped zinc sulphide layer may be up to 0.5 μm in thickness, and the p-type silicon layer may be 1 to 20 μm in thickness.

In order that the invention might be more fully understood, embodiments thereof will now be described, by way of example only, with reference to the accompanying drawings, in which:

Figure 1 is a schematic drawing of an electroluminescent device of the invention,

Figure 2 shows the device of Figure 1 with the addition of a transition metal oxide layer,

Figure 3 shows the device of Figure 2 with additional p-type and n-type silicon layers,

Figure 4 shows the device of Figure 2 with the addition of a control electrode,

Figures 5 and 6 are schematic drawings of the electroluminescent device of the invention incorporating amorphous silicon layers, and

Figure 7 illustrates the current-voltage characteristics of the invention.

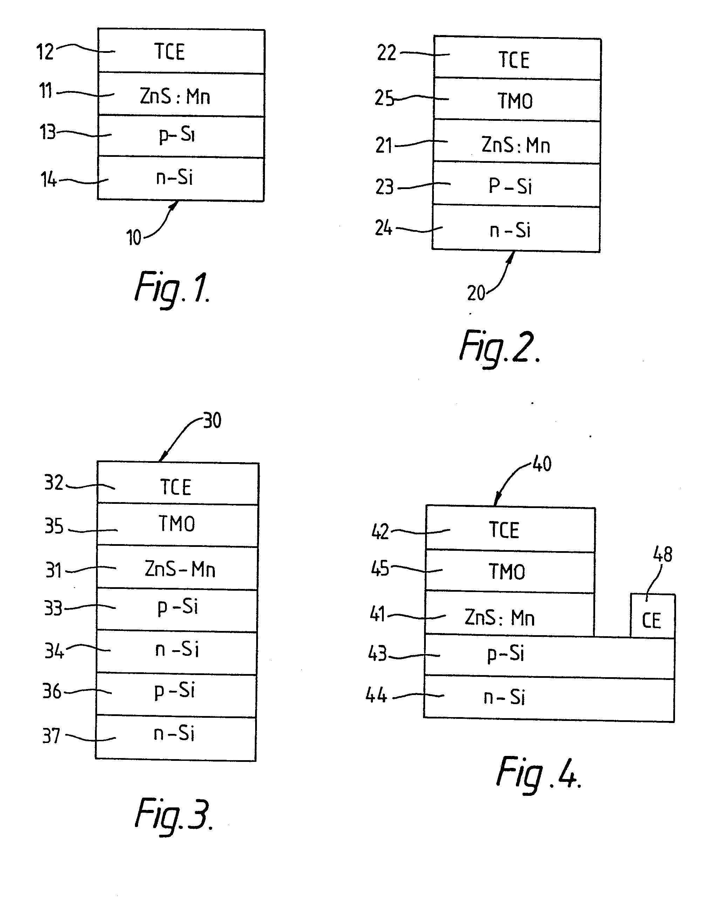

Referring to Figures 1 and 2, an electroluminescent device 10 comprises a manganese-doped zinc sulphide layer 11 sandwiched between a transparent conducting electrode 12 and layers of p-type and n-type silicon 13 and 14. The ZnS:Mn layer is between 0.2 μm and 0.5 μm in thickness. The electrode 12 is of either Indium-Tin-Oxide or substoichometric Tin Oxide. A similar device structure 20 is shown in Figure 2, except that an additional layer 25 of a transition metal oxide lies between the transparent conducting electrode 22 and the electroluminescent layer 21 supported by p-type and n-type silicon layers 23 and 24. The purpose of the oxide layer 25 is to provide self-healing of any pinholes created in the electroluminescent layer 21. The oxide may be that of manganese, tungsten or molybdenum.

The p-Si layers 13 and 23 of the devices 10 and 20 are between 1 μm and 20 μm in thickness. The ZnS:Mn layers 11 and 21 may be deposited by radio-frequency sputtering, high vacuum evaporation or ultra-high vacuum evaporation to produce epitaxial layers of ZnS:Mn on silicon. Alternatively, the ZnS:Mn layers may be grown from organometallic vapours followed by either thermal, electron-beam or laser annealing. Ion implantation techniques may also be employed.

The devices 10 and 20 are operated by applying a steady or pulsed dc supply between the electrode 12 or 22 and the n-Si layer 14 or 24. A constant current source may be used. The devices 10 and 20 each form a heterojunction or transistor-like structure which limits the total device current during operation. However, limiting the total current does not exclude local current variations over the ZnS:Mn layer 11 or 21 arising from film thickness variation. At thin portions of the layer 11 or 21, local high electric fields may produce pinholes. The purpose of the transition metal oxide layer 25 is to self-heal such pinholes.

During operation of either of the devices 10 and 20, ie when light is emitted from the ZnS:Mn layer 11 or 21, the rate of increase of the total device current is lower than the rate of increase at electric fields below the luminescent field. Accordingly, these devices inhibit current runaway, unlike prior art devices. This characteristic arises from the intrinsic properties of the p-Si/ZnS:Mn heterojunction between layers 13 or 23 and 11 or 21.

Referring now to Figure 3, there is shown a further electroluminescent device 30. The device 30 comprises a ZnS:Mn layer 31 between transition metal oxide and p-Si layers 35 and 33 respectively. The p-Si layer 33 is between 1.0 μm and 20 μm in thickness. The metal oxide layer 35 is covered by a transparent electrode 32, and the p-Si layer 33 is supported by successive n-Si, p-Si and n-Si layers 34, 36 and 37 respectively. The device 30 is equivalent to an n-p-n bipolar transistor, comprising layers 34, 36 and 37, in series with the p-Si and ZnS:Mn layers 33 and 31. This corresponds to devices 10 and 20 incorporating a silicon transistor, instead of employing a separate transistor operating in the constant current mode and external to the matrix of integrated display elements. The device 30 is equivalent to the devices 10 and 20, apart from the additional p-Si and n-Si layers 36 and 37, since the transition metal oxide layer 35 may be omitted if low field operation is envisaged and self-healing properties are not required.

Referring now to Figure 4, there is shown a further embodiment of the invention comprising a ZnS:Mn layer 41 sandwiched between a transition metal oxide layer 45 and a p-Si layer 43. The metal oxide layer 45 has a superimposed transparent conducting electrode 42, and the p-Si layer 43 is supported by an n-Si layer 44. An ohmic contact 48 provides a connection to the p-Si layer 43.

The device 40 operates as follows. The contact 48 provides a control electrode giving independent control of the current in the device 40. In comparison, the device 10 employs a bias voltage between layers 12 and 14 both to supply current and to energise carriers to create impact ionisation of the luminescent centres, devices 20 and 30 being equivalent. In the device 40, the ohmic contact 48 is used to inject current. Hence in operation a dc bias is applied between the electrode 42 and n-Si layer 44, but carrier density is controlled independently by means of a bias applied to the contact 48.

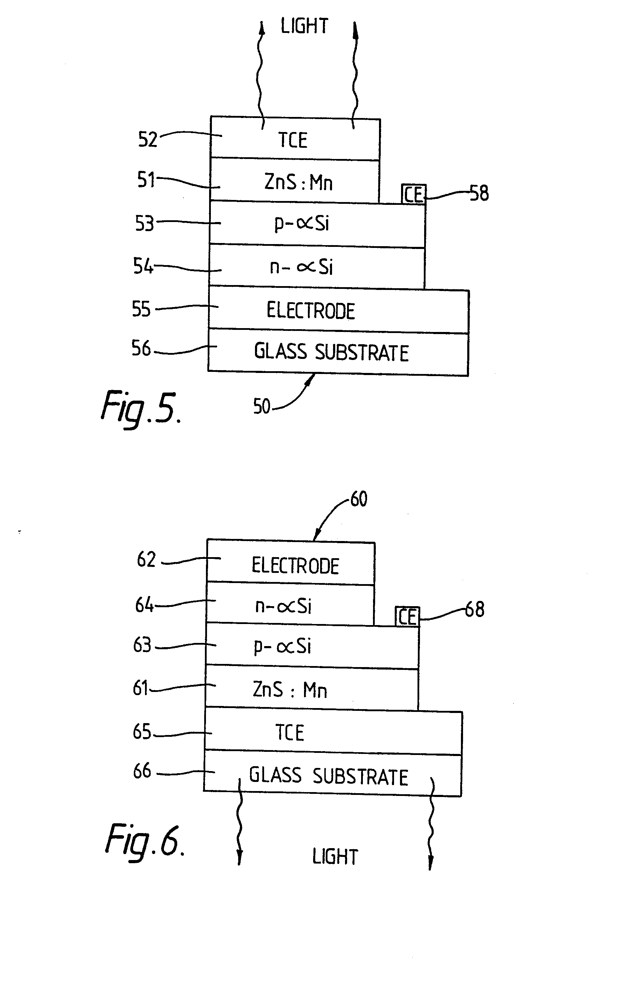

Referring now to Figure 5, there is shown an electroluminescent device 50 comprising a ZnS:Mn layer 51 between a top transparent conducting electrode 52 and successive p-type and n-type amorphous silicon layers 53 and 54. The n-amorphous Si layer 54 is supported on a bottom electrode 55 laid over a glass substrate 56. The device 50 includes an ohmic contact 58 to the p-amorphous Si layer 53 providing a control electrode. Electroluminescent operation is produced by applying dc pulses between the top electrode 52 and the bottom electrode 55, the control electrode 58 being employed to modulate the device characteristics. The device 50 is similar to the device 10 with the addition of a control electrode as in the device 40. The use of amorphous silicon for the layers 53 and 54 makes it possible to use an amorphous (glass) substrate 56 and standard thin film deposition techniques. This affords the possibility of fabricating large-area electroluminescent displays.

Structures equivalent to devices 10, 20, 30 and 40 may be produced by replacing the crystalline silicon layers therein by amorphous silicon layers as in the device 50.

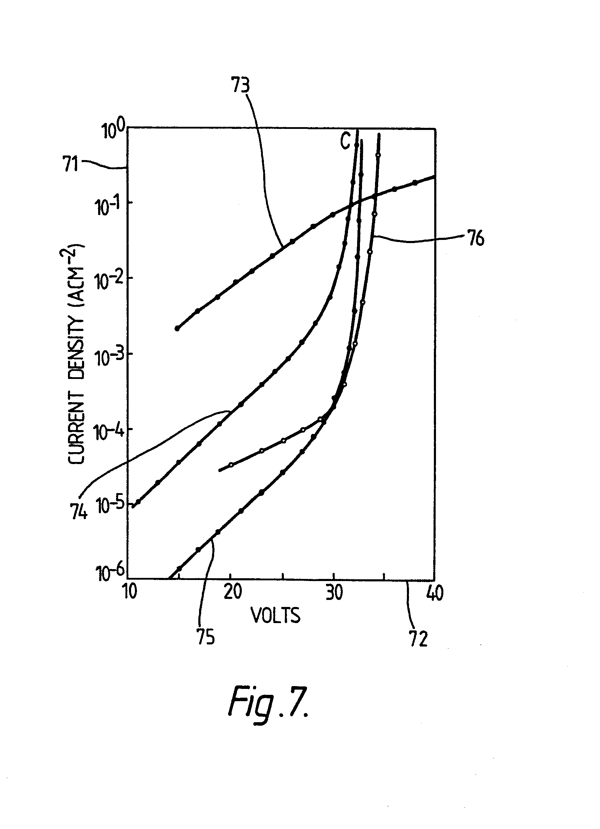

Referring now to Figure 6, there is shown a further device 60 of the invention comprising a ZnS:Mn electroluminescent layer 61 between a bottom transparent conducting electrode 65 on a glass substrate 66 and successive p-type and n-type amorphous silicon layers 63 and 64. A top electrode 62 covers the n-amorphous Si layer 64. A control electrode 68 is attached to the p-amorphous Si layer 63. The device 60 is equivalent to an inverted version of the device 50, and is biassed similarly. Electroluminescent light is however emitted through the glass substrate 65, which is an advantage for display applications requiring output through a glass surface.

On the 19th October 1982, the inventors of the present invention presented a paper at the 1982 IEEE International Display Research Conference giving performance details for devices of the invention. For convenient reference, parts of the paper are repeated here.

Prototype or test devices similar to the device 10 shown in Figure 1 were fabricated. In each case, a p-Si layer 13 was produced by diffusion of acceptors to a concentration of $\sim 10^{16}$ cm$^{-3}$ to a depth of $\sim 10$ µm into an n$^{-}$-type epilayer deposited on a crystalline n$^{+}$-Si substrate. The treated substrates were then diced, cleaned and chemically heat-treated at 500°C for $\sim 30$ minutes in a vacuum of $\sim 10^{-6}$ Torr to remove adsorbed moisture. ZnS:Mn layers 11 with thicknesses between 0.2 µm and 0.4 µm were deposited on the p-Si layers 13 by radio-frequency sputtering a suitable solid target. During the sputtering process the substrates were maintained at a temperature of 200°C. Atomic absorption spectroscopy showed an Mn-doping level of 0.7 atomic %. For some devices a control electrode was applied to the p-Si layer in the manner described with reference to Figure 4, but no reportable data were obtained.

To complete the prototype device, either Indium Tin Oxide (ITO) or Aluminium films of 1 mm diameter were deposited on to the ZnS:Mn layers to provide electrodes. This gave an ITO or Al/ZnS:Mn/p-n$^{+}$Si structure with the ZnS:Mn layer $\sim 0.3$ µm in thickness.

For comparison purposes, electroluminescent devices were also fabricated which lacked the combined p-n⁺Si layers. These comparison devices had the structures ITO/ZnS:Mn/p⁺Si, ITO/ZnS:Mn/n⁺Si and ITO/ZnS:Mn/Aℓ where the ZnS:Mn layer was 0.18 to 0.2 μm in thickness.

Figure 7 provides graphs of current density on a logarithmic scale 71 against device voltage on a linear scale 72 for the test and comparison devices mentioned above. Graph 73 shows the performance of an Aℓ/ZnS:Mn/p-n⁺Si test device of the invention when the n⁺ substrate is negatively biassed (forward bias condition, no appreciable current flows in the reverse bias direction). Graphs 74, 75 and 76 show the behaviour of the comparison device structures ITO/ZnS:Mn/p⁺Si, ITO/ZnS:Mn/n⁺Si and ITO/ZnS:Mn/Aℓ respectively.

The graphs 74, 75 and 76 all have an upcurved shape and illustrate rapid current runaway above an applied voltage of 30 V. This is characteristic of the behaviour of prior art devices. Graph 73 for the device of the invention has however a 'knee' in the 30 V region, at which luminescence occurs, and does not show any tendency to current runaway since its curvature is of opposite sign to that of graphs 74 to 76.

It was also found that devices of the invention typically showed a decay in brightness of less than 5% after 12 hours continuous operation at ~ 15 ft-Lamberts (51.4 candelas/metre²). The devices were driven by a pulsed dc supply having a 20 μsec pulse width and a 0.3% duty cycle. A similarly small reduction was observed when the devices were driven with dc pulses of 4 milliseconds duration with a 0.4% duty cycle. This compares with a half-life (time to decay to 50% of original brightness) of at best $\lesssim$ 12 hours at ~ 12 ft-Lamberts (41 candelas/metre²) for the ITO/ZnS:Mn/Aℓ structures similar to prior art devices.

Accordingly, electroluminescent devices of the invention both inhibit current runaway and exhibit improved luminescence life-time compared to prior art devices

## CLAIMS

1.    An electroluminescent device (10,...60) including an electroluminescent layer (11,...61) characterised in that the device also includes a p-type silicon layer (13,...63) and an n-type silicon layer (14,...64).

2.    An electroluminescent device (10,...60) according to claim 1 characterised in that the electroluminescent layer (11,...61) is manganese-doped zinc sulphide.

3.    An electroluminescent device (10,...60) according to claim 2 characterised in that the n-type silicon layer (14,...64) has $n^+$ doping.

4.    An electroluminescent device (20,30,40) according to claim 3 characterised in that the electroluminescent layer (21,31,41) is in contact with a transition metal oxide layer (25,35,45) non-contiguous with the silicon layers (23,24,...43,44).

5.    An electroluminescent device (40,50,60) according to any preceding claim characterised in that the p-type silicon layer (43,53,63) is connected to a control electrode (48,58,68).

6.    An electroluminescent device (10,...60) according to any preceding claim characterised in that the electroluminescent layer (11,...61) is up to 0.5 μm in thickness.

7.    An electroluminescent device (10,...60) according to claim 6 characterised in that the p-type silicon layer (13,...63) is between 1 μm and 20 μm in thickness.

8.    An electroluminescent device (50,60) according to any preceding claim characterised in that the silicon layers (53,54,63,64) are amorphous.

9.   An electroluminescent device (30) according to any preceding claim characterised in that the device (30) incorporates additional p-type and n-type silicon layers (36 and 37).

Fig.1.

| 12 | TCE |
|---|---|
| 11 | ZnS : Mn |
| 13 | p–Si |
| 14 | n–Si |

10

Fig.2.

| 22 | TCE |
|---|---|
| 25 | TMO |
| 21 | ZnS : Mn |
| 23 | P – Si |
| 24 | n – Si |

20

Fig.3.

30

| 32 | TCE |
|---|---|
| 35 | TMO |
| 31 | ZnS – Mn |
| 33 | p – Si |
| 34 | n – Si |
| 36 | p – Si |
| 37 | n – Si |

Fig.4.

40

| 42 | TCE | |
|---|---|---|
| 45 | TMO | |
| 41 | ZnS : Mn | 48 CE |
| 43 | p–Si | |
| 44 | n – Si | |

LIGHT

| | |
|---|---|
| 52 | TCE |
| 51 | ZnS : Mn |
| 53 | p-∝Si |
| 54 | n-∝Si |
| 55 | ELECTRODE |
| 56 | GLASS SUBSTRATE |

CE — 58

50

Fig.5.

60

| | |
|---|---|
| 62 | ELECTRODE |
| 64 | n-∝Si |
| 63 | p-∝Si |
| 61 | ZnS : Mn |
| 65 | TCE |
| 66 | GLASS SUBSTRATE |

CE — 68

Fig.6.

LIGHT

Fig.7.